# EUROPEAN PATENT SPECIFICATION

(11) **EP 0 978 844 B1**
(45) Date of publication and mention of the grant of the patent: **02.11.2005**
(21) Application number: 98830491.1
(22) Date of filing: 07.08.1998
(51) Int. Cl.: G11C 11/56

(54) **Sensing arrangement for a multilevel semiconductor memory device**
Ausleseanordnung für Multibit-Halbleiterspeicheranordnung
Dispositif de détection pour une mémoire multiétats à semiconducteurs

(43) Date of publication of application: 09.02.2000
(73) Proprietor: STMicroelectronics S.r.l., 20041 Agrate Brianza (Milano) (IT)
(72) Inventor: Calligaro, Cristiano, 27020 Torre d'Isola (PV) (IT); Rolandi, Paolo, 27058 Voghera (PV) (IT); Gastaldi, Roberto, 20041 Agrate Brianza (MI) (IT); Torelli, Guido, 27016 S. Alessio con Vialone (PV) (IT)
(74) Representative: Mittler, Enrico

(56) References cited:
- EP-A- 0 337 433
- US-A- 5 675 537

## Description

The present invention relates to multilevel semiconductor memory devices, particularly multilevel non-volatile semiconductor memory devices. More particularly, but not exclusively, the invention relates to multilevel non-volatile semiconductor memory devices wherein the memory cells comprise MOS transistors and the programming of the memory cells is achieved by means of a change in the threshold voltage of the MOS transistor. Still more particularly, but not exclusively, the invention relates to multilevel non-volatile memory devices such as EPROMs, EEPROMs, Flash EEPROMs, wherein the memory cells comprise floating-gate MOS transistors.

In multilevel memory devices each memory cells can take one among *m* distinct predetermined programming states. This means, if *m* = 2^{*n*} , the memory cell can store *n* = log₂ *m* bits of information. Clearly, a multilevel memory device with a given area has a memory capacity much higher than an equivalent bilevel memory device of the same area.

Conventionally, a non-volatile memory cell of the memory cell array or matrix (in the following called for the sake of simplicity matrix memory cell) is read (or "sensed") by comparing the threshold voltage of such a memory cell with the threshold voltage of so-called reference memory cells shortly, reference cells, properly programmed. The reference memory cells are structurally identical to the matrix memory cells: this assures a good matching of characteristics between the reference and the matrix memory cells, and improves the precision of the matrix cell sensing operation. The matrix memory cells can take one of *m* distinct threshold voltage levels; if the threshold voltages of the reference memory cells are properly set, the comparison between the threshold voltage of the matrix memory cells and that of the reference memory cells univocally provides the information corresponding to the data stored in the matrix memory cells.

In the practice, sensing of a given matrix memory cell is performed by biasing in substantially identical conditions both the matrix memory cell and the reference memory cells. This means, the voltages applied to the drain, gate, source and bulk terminals of the matrix memory cell are substantially identical to those applied to the respective terminals of the reference memory cells. Then, the current sunk by the matrix memory cell is compared with the currents sunk by the reference memory cells. Given the biasing conditions, there is a one-to-one relationship between the threshold voltage of a memory cell, be it matrix or reference, and the current sunk by the same; clearly, a higher threshold voltage will correspond to a lower current sunk.

In the case of bilevel memory cells, the matrix cell current, in the predetermined biasing conditions, can be either zero (matrix cell programmed so to have a high threshold voltage value, programming state *0*) or substantially equal to a predetermined nominal value (matrix cell programmed so to have a low threshold voltage, programming state *1*). The reference memory cell can be programmed so as to sink, in the predetermined biasing conditions, the same current sunk by a matrix cell in the *1* programming state. It is thus simple to determine, by current comparison, the programming state of the matrix cell. And it is also simple to program the reference memory cells.

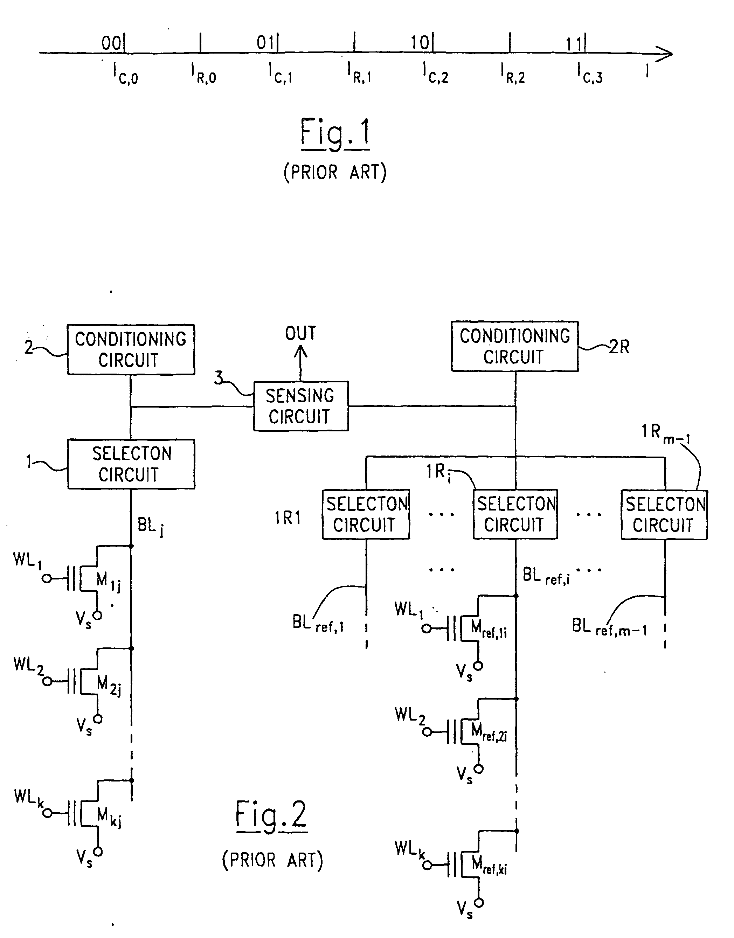

In the case of multilevel memory cells with *m* distinct possible values for the threshold voltage, the matrix cell current is to be compared with *m* - 1 properly set reference currents. Fig. 1 shows the case of a four-level matrix memory cell which can assume four different threshold voltage values, corresponding, in the prescribed sense biasing conditions, to four matrix cell currents I_{C,0} to I_{C,3}. For each matrix cell current there is also indicated the corresponding value of a two-bit digital code stored in the matrix memory cell. I_{R,0} to I_{R,2} are the three values of the reference cell currents to be compared with the matrix cell current. Advantageously, the reference current values fall in the middle of the intervals between adjacent matrix cell currents, i.e., ideally, I_{R,i} = 1/2 (I_{C,i} + I_{C,i+1}), with i = [0; *m* - 2]. Whichever the programming state of the matrix memory cell, comparison of the matrix cell current with the reference cell currents provides univocally the information stored in the matrix memory cell. By way of example, if the data stored in the matrix memory cell is "10", the matrix cell current I_{cell} is equal to I_{C,2}. The comparison will give a negative result for every reference cell current I_{ref} higher than I_{R,1}, while it will give a positive result for every reference cell current I_{ref} lower than or equal to I_{R,1}. A similar situation occurs for every other possible value of the memory cell current I_{cell}, and for every value of *m* different from 4.

Setting the reference cell currents in the middle between adjacent matrix cell currents provides the best margin against data retention degradation and operating condition changes.

It is to be noted that even if *m* - 1 distinct reference current values suffice for a correct sensing of the data stored in a multiple level memory cell with *m* distinct programming levels, nothing prevents from using an additional reference current value, either higher than I_{C,*m* - 1} or lower than I_{C,0} (clearly in the case I_{C,0} > 0), or even both of said additional reference values, even if this is not strictly necessary.

Figure 2 shows schematically a sensing arrangement for reading multilevel memory cells in a memory matrix. This arrangement is clearly a straightforward extension of the conventional sensing arrangement for bilevel memory cells. In the drawing, BLⱼ is representative of one of a plurality of matrix bit lines. Mₗⱼ to Mₖⱼ are multilevel matrix memory cells of the memory matrix belonging to the j-th bit line BLⱼ. Matrix memory cells Mₗⱼ to Mₖⱼ have their drain electrodes connected to bit line BLⱼ. WL₁ to WLₖ are the word lines of the memory matrix, and each memory cell of bit line BLⱼ has the control gate electrode connected to a respective one of word lines WL₁ to WLₖ. When a word line is selected, its voltage is brought to a prescribed positive value, suitable for optimizing the sense operation; the remaining word lines are normally kept at ground. The source electrodes of the matrix memory cells are connected to a low-impedance source line Vs, substantially a voltage generator; conventionally, in EPROM devices source line Vs is the ground; in Flash EEPROMs Vs is a line common to all the memory cells of a memory sector, and it can be switched between a read voltage (normally, ground) and an erase voltage.

A number of matrix bit lines are connected to a selection circuit 1 which selects one among all the said number of matrix bit lines connected thereto according to address signals not shown. Selection circuit 1 allows to connect the selected matrix bit line to a conditioning circuit 2 and to a sensing circuit 3. Conventionally, the conditioning circuit 2 includes circuits for biasing the selected bit line, i.e. for biasing the drain electrodes of the matrix memory cells connected to the selected bit line, as well as preset circuits such as for example precharge circuits. This is well known to the skilled reader, and will not be explained in further detail.

At the reference side, *m* - 1 reference bit lines BL_{ref,l} to BL_{ref,m-1} of reference memory cells (e.g., M_{ref,li} to M_{ref,ki} for reference bit line BL_{ref,i}) are each one connected to a respective selection circuit 1R₁ to 1Rₘ₋₁. Selection circuits 1R₁ to 1Rₘ₋₁ allow to connect one of the reference bit lines to a conditioning circuit 2R and to the sensing circuit 3. The conditioning circuit 2R performs similar functions as conditioning circuit 2.

Sensing circuit 3 performs the comparison between the matrix cell current flowing through the selected matrix bit line, and the reference cell current flowing through the selected reference bit line. Output terminal OUT of the sensing circuit 3 provides the information corresponding to the data stored in the selected matrix memory cell sensed.

Each reference memory cell of a reference bit line has the drain electrode connected to the reference bit line, the control gate electrode connected to a respective one of the word lines WL₁-WLₖ, and the source electrode connected to the source line Vs. This assures a good matching between the matrix memory cells to be sensed and the reference memory cells that are used for comparison, since when a matrix memory cell of a given word line is to be sensed, reference memory cells belonging to the same word line are used. In order to further improve the matching, the reference bit lines can be located inside the matrix of memory cells.

All the reference memory cells that, such as reference memory cells M_{ref,l} to M_{ref,k}, belong to a same reference bit line such as BL_{ref,i}, are programmed at the same level. This means, considering for example the case of four-level memory cells shown in Fig. 1, that three reference bit lines at least are to be provided, a first reference bit line made of reference cells all programmed at the level corresponding to current I_{R,0}, a second reference bit line made up of reference cells all programmed at the level corresponding to current I_{R,1}, and a third reference bit line made up of reference cells all programmed at the level corresponding to current I_{R,2}.

This technique optimize the matching between the reference memory cells and the matrix memory cells. The reference memory cells are in fact structurally identical to the matrix memory cells, are fabricated simultaneously with and by means of the same process steps as the matrix memory cells and therefore are affected by same deviations from ideality. Additionally, during the sensing phase, one of the two input terminals of the sensing circuit (comparator) is connected to the matrix bit line to which the matrix memory cell to be sensed belongs, and the other input terminal is connected to one of the reference bit lines, not to a single reference cell. This assure a pretty good dynamic matching, since the capacitive loads seen by the sensing circuit at the matrix side are quite the same as those seen at the reference side. The whole sensing operation, inclusive of the pre-charge phase and the very sensing phase, is therefore optimized. The same beneficial effects are encountered in the "program verify"' step in electrically programmable memory devices, step that provides for sensing a programmed matrix cell under programming to detect if it has really been programmed at the desired level.

However, this solution poses some problems when applied to multilevel memory cells. Actually, a large number of reference memory cells, specifically all the reference cells of a given reference bit line, are to be programmed at the same programming level. The problems involved are, from one hand, the lenghty programming step of all the reference memory cells and, from the other hand, the difficulty in precisely programming all the reference memory cells of a given reference bit line to the very same programming level. The time to be dedicated to the programming of the reference memory cells increases with the precision of their programming, and with the increase of the number of programming levels of the matrix cells.

Clearly, the use of a single reference memory cell in lieu of a whole reference bit line of reference memory cells would solve the above-mentioned problems, but at the expense of a good matching between the circuit branch at the memory cell matrix side and the circuit branch at the reference memory cell side.

The patent US 5,675,537 discloses an erasing scheme for performing an erasing operation in an array of two bits per cell flash EEPROM memory cell. The erase verify reference column is comprised of an erase verify reference cell and a plurality of dummy erase verify cells DC₁₁, ..., DCₙ₁. There are also dummy erase reference cells DA1-Dan and DR1-DR3 associated with respective array bit lines and reference bit lines. The dummy erase verify cells DC₁₁, ..., DCₙ₁ have the source connected to Vss, the gate connected to the respective word line and the drain is floating. The dummy erase reference cells DA1-Dan and DR1-DR3 have the drain connected to the respective reference bit line, the source connected to Vss and the gate connected to ground.

The patent application EP 337 433, discloses a memory cell array which includes data storing memory cells which are arranged in a matrix form of m x n columns. Dummy capacitance cells are arranged on the (n+1)th column of the memory cell array, and are connected to the word lines. The dummy capacitance cells are each formed of a transistor which has the same construction as a polyfield transistor with a floating gate or the data storing memory cell and whose source is set in the electrical floating condition.

In view of the state of the art described, it has been an object of the present invention that of providing a multilevel memory device suitable for assuring a good matching during sensing between the matrix bit line containing the memory cell to be sensed and the reference bit lines, but at the same time overcoming the problems of the conventional ones.

According to the present invention, such an object is attained by means of a multilevel memory device, according to claim 1.

The features and advantages of the present invention will be made apparent by the following detailed description of some particular embodiments thereof, illustrated by way of non-limiting examples only in the annexed drawings, wherein:
Figure 1 diagramatically shows a conventional, optimum placement of reference levels for the sensing of four-level memory cells;
Figure 2 shows a sensing arrangement for a multilevel memory device which is a straightforward extension of a conventional sensing arrangement for bilevel memory cells;
Figure 3 shows a sensing arrangement for a multilevel memory device which is not part of the claimed invention;
Figure 4 shows a sensing arrangement for a multilevel memory device which is not part of the claimed invention;
Figure 5 shows a sensing arrangement for a multilevel memory device which is not part of the claimed invention;
Figure 6 shows in top-plan view the layout of a portion of a memory cell array of the multilevel memory device shown in Figure 4;
Figure 7 shows a schematic cross-section along line VII-VII of Figure 6;
Figure 8 shows the same portion of memory cell array shown in Figure 6, but obtained by a different manufacturing process;
Figure 9 shows a sensing arrangement for a multilevel memory device according to a first embodiment of the present invention;
Figure 10 shows a sensing arrangement for a multilevel memory device according to a second embodiment of the present invention; and
Figure 11 shows a sensing arrangement for a multilevel memory device according to a third embodiment of the present invention.

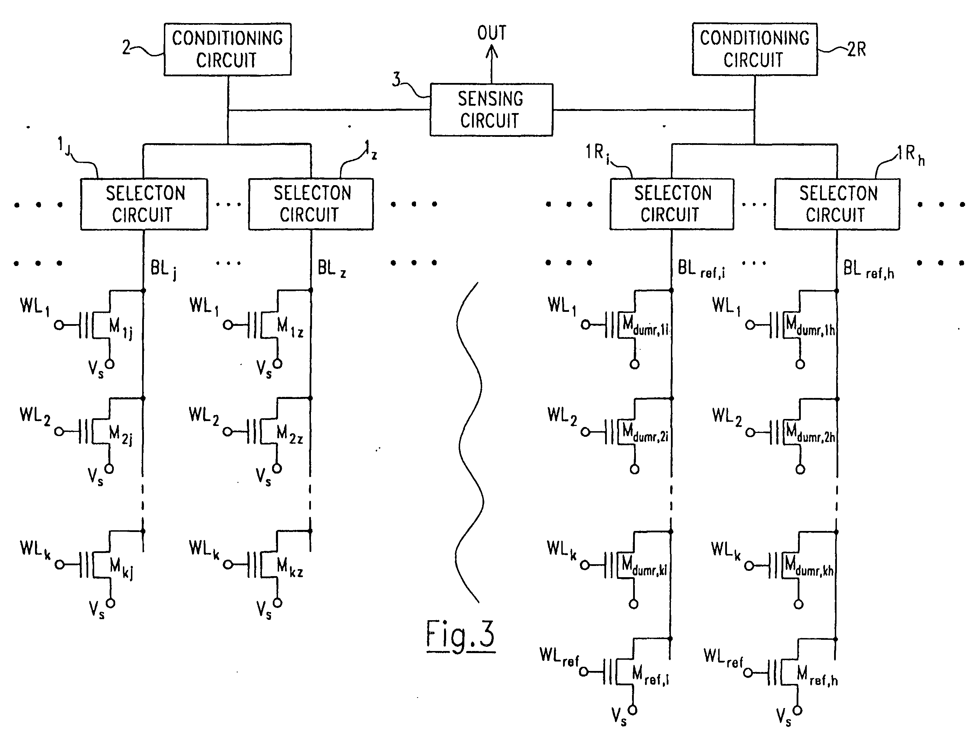

Referring to Fig. 3, a sensing arrangement for a multilevel memory device which is not part of the claimed invention is shown. In the drawing, two matrix bit lines BLⱼ, BL_{z} of multilevel memory cells Mₗⱼ to Mₖⱼ and M_{lz} to M_{kz} are shown, representative of a plurality of matrix bit lines of a memory matrix or memory sector of the multilevel memory device. Each matrix bit line is connected to a respective selection circuit such as 1ⱼ, 1_{z}, operating the selection of the respective bit line. The outputs of the selection circuits 1ⱼ, 1_{z} are connected to a conditioning circuit 2 and to a sensing circuit 3. Each matrix bit line contains a number of matrix multilevel memory cells equal to the number of word lines WL₁ - WLₖ of the memory matrix or memory sector.

At the reference side, two reference bit lines BL_{ref,i} and BL_{ref,h} representative of a plurality of *m*-1 (at least) reference bit lines are shown. Each reference bit line is connected to a respective selection circuit 1Rᵢ, 1Rₕ operating the selection of the respective reference bit line; selection circuits 1Rᵢ, 1Rₕ are similar to those provided for the matrix bit lines. The outputs of the selection circuits 1Rᵢ, 1Rₕ are supplied to a conditioning circuit 2R and to the sensing circuit 3.

Each reference bit line contains a number of dummy memory cells M_{dumr,li} - M_{dumr,ki} and M_{dumr,lh} to M_{dumr,kh} equal to the number of word lines WL₁ to WLₖ of the memory matrix or sector. Additionally, each reference bit line contains a further reference multilevel memory cell M_{ref,i} and M_{ref,h}. The dummy memory cells have a drain electrode connected to the respective reference bit line, a control gate electrode connected to a respective word line WL₁, WLₖ, but their source electrode is left floating. Differently, the reference memory cell M_{ref,i}, M_{ref,h} of each reference bit line has a drain electrode connected to the respective reference bit line, a control gate electrode connected to a reference word line W_{ref} distinct from the matrix word lines WL₁ - WLₖ, and a source electrode connected to the same source line Vs as the source electrodes of the matrix memory cells. The dummy memory cells are structurally identical to the matrix memory cells and the reference memory cells. For each reference bit line, the respective reference memory cell is programmed at a prescribed level so that, under the prescribed bias conditions, the current flowing through the reference bit line is that required for performing the comparison with the current flowing through the selected matrix bit line; for example, in the case of four-level memory cells, as reported in Fig. 1, three reference bit lines are at least necessary, and the respective three reference memory cells of such reference bit lines will have to be programmed to levels corresponding to the reference current values I_{R,0}, I_{R,1} and I_{R,2}. Differently, the dummy cells of the reference bit lines are not to be programmed in any particular programming level, since being their source electrodes floating the dummy cells will never contribute to the current flowing through the respective reference bit line.

During the sensing phase, the matrix bit line containing the addressed matrix memory cell is selected by the respective selection circuit, and it is connected to the sensing circuit. Also the matrix word line containing the addressed matrix memory cell is selected. Thus, the addressed memory cell will sink a current that depends on the particular programming level.

The reference word line WL_{ref} is also selected, and the reference bit lines are connected, one at a time, to the sensing circuit 3. The only current flowing through the reference bit line is that contributed by the respective reference memory cell; in fact, even if the dummy cell of the reference bit line having its control gate electrode connected to the selected matrix word line will be selected, such a dummy cell does not contribute any current being its source electrode floating.

Clearly, connection of only one reference bit line at a time to the sensing circuit 3, that is a so-called "serial sensing" of the matrix memory cells, is just one of the possible sensing approaches which have been proposed in the art for multilevel memory; other approaches are for example the parallel and the mixed serial-parallel. It is apparent that the present invention applies as well to the other sensing approaches not only to the serial sensing described for simplicity.

If desired, in order to achieve a better matching between the matrix memory cells and the reference memory cells, the reference bit lines can be placed inside the memory matrix, adjacent to matrix bit lines.

For each reference bit line, the respective reference memory cell can be placed anywhere, either at the top, or at the bottom of the reference bit line, as well as in any other position, such as at the middle of the reference bit line.

It appears that thanks to the present arrangement, each reference bit line is physically and electrically substantially identical to a generic matrix bit line. In fact, each reference bit line includes substantially the same number of memory cells as any matrix bit line: the mismatch between the matrix bit lines and the reference bit lines is 1/k, where k is the number of word lines of the memory matrix, i.e. the number of matrix memory cells attached to each matrix bit line. Thus, the capacitive loads seen by the sensing circuit at the reference side will be substantially equal to those seen at the matrix side.

However, compared to the conventional arrangement shown in Fig. 2, it is not necessary to program all of the memory cells connected to a reference bit line to a same programming level. Indeed, only the reference memory cells M_{ref,i}, M_{ref,h} are to be programmed to the respective programming level, because these are the only cells that contribute to the reference current.

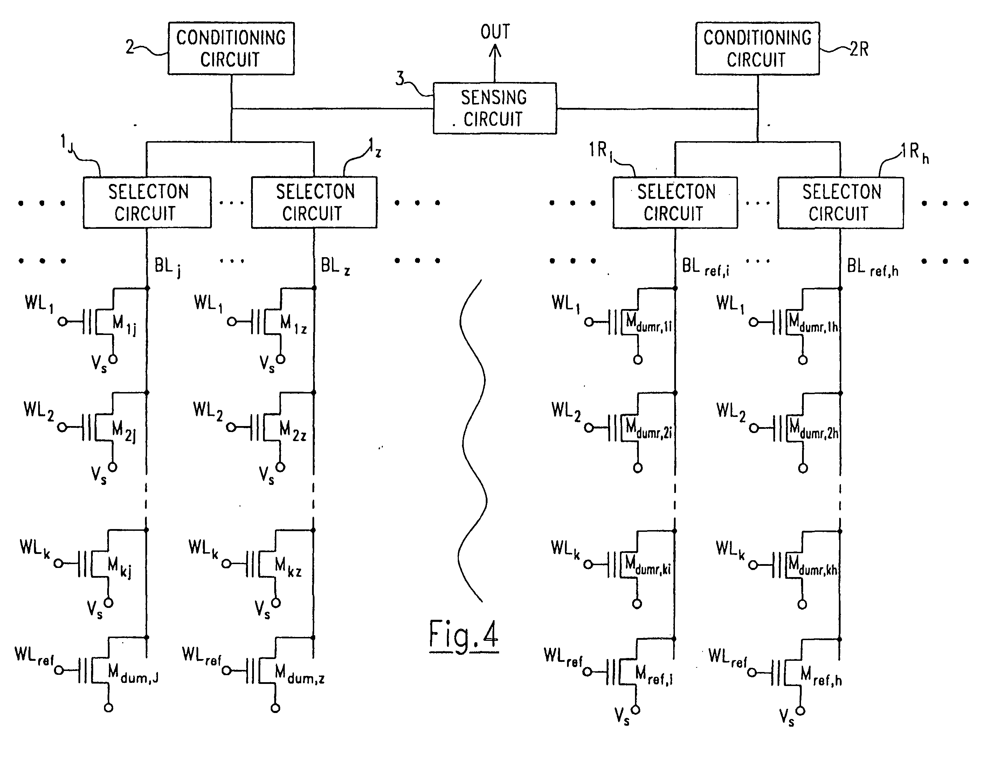

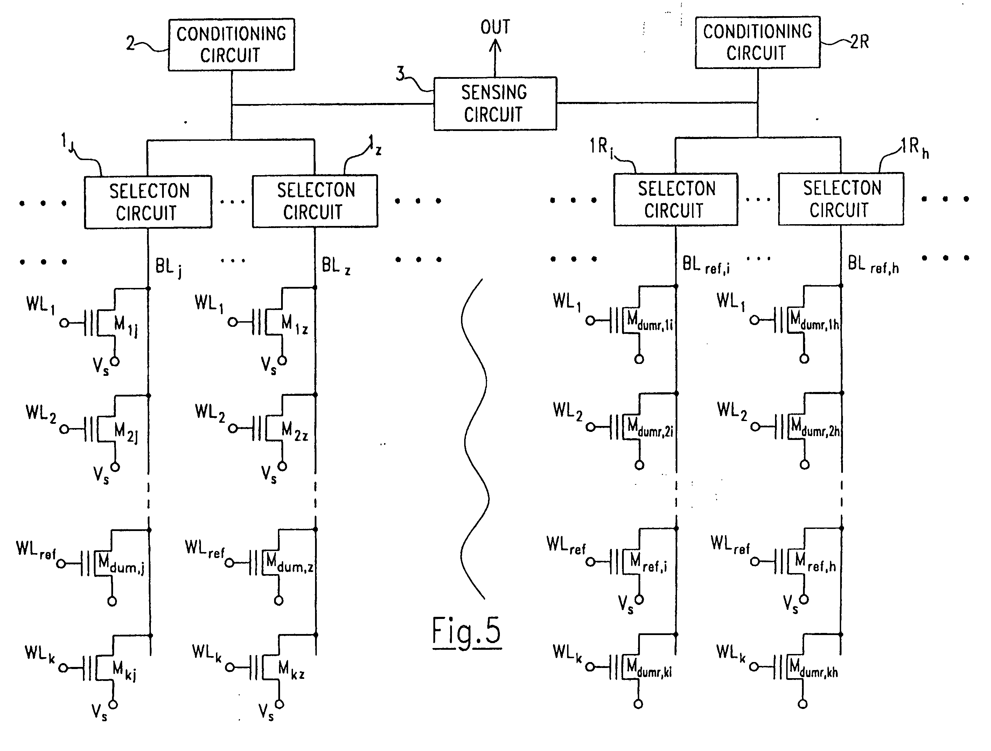

Sensing arrangements for multilevel memory devices which are not part of the claimed invention are shown in Figs. 4 and 5. In the arrangement of Fig. 4, differently from the previous one, a dummy memory cell M_{dum,j}, M_{dum,z} with floating source electrode is additionally connected to each matrix bit line BLⱼ, BL_{z}. The control gate electrodes of the dummy memory cells of the matrix bit lines are connected to the reference word line WL_{ref}. In this way, the matching between the matrix bit lines and the reference bit lines is improved and it is almost perfect, since the former includes exactly the same number of memory cells as the latter. Clearly, being the source electrode of the dummy memory cells of the matrix bit lines floating, they do not contribute any current to the matrix bit line current. In the arrangement of Fig. 4 the reference memory cells M_{ref,i}, M_{ref,h} attached to the reference bit lines and the dummy memory cells M_{dum,j}, M_{dum,z} attached to the matrix bit lines are located at one end of the matrix and reference bit lines. However, the reference memory cells and the dummy memory cells could be located anywhere along the respective bit lines. For example, in the arrangement of Fig. 5 the dummy memory cells and the reference memory cells are located in the middle of the respective bit lines.

As an alternative embodiment, for optimizing the matching between the matrix bit lines and the reference bit lines it is possible, instead of adding a dummy memory cell to each matrix bit line, to eliminate one dummy memory cell from each reference bit line, so that the number of memory cells connected to the matrix bit lines and to the reference bit lines is always equal to k.

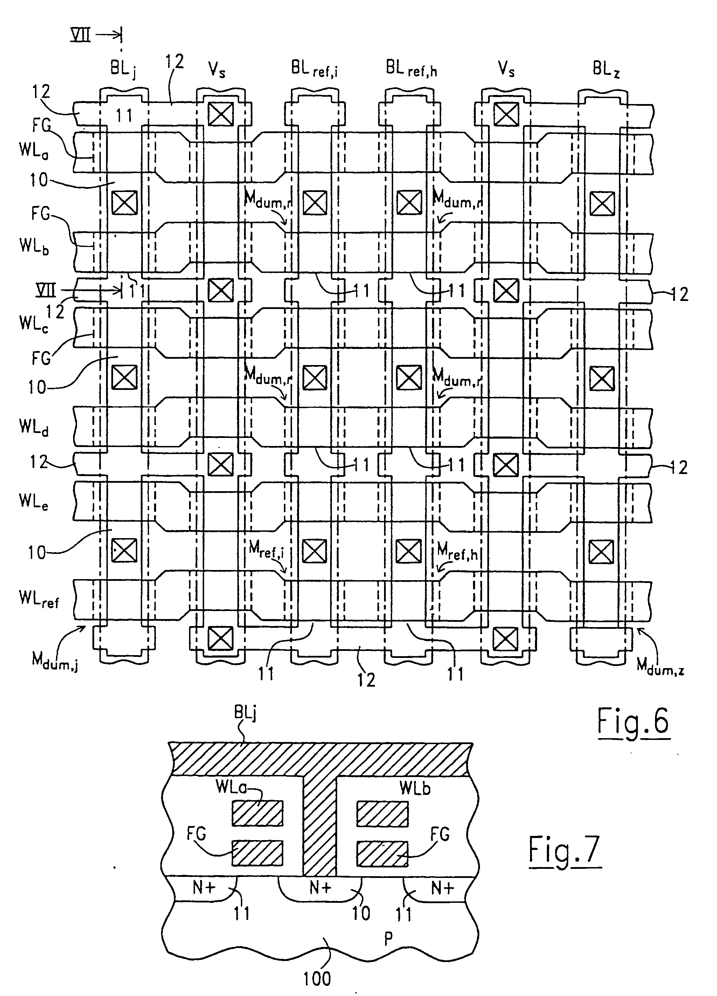

Fig. 6 is a schematic top-plan view of a portion of a memory cell array of a multilevel memory device implementing the sensing arrangement of Fig. 4. Fig. 7 is a schematic cross-sectional view showing two adjacent matrix memory cells belonging to matrix bit line BLⱼ and respectively connected to matrix word lines WLₐ and WL_{b}. However, since the reference memory cells and the dummy memory cells all have identical structure, Fig. 7 can be though to refer to any pair of adjacent cells in the memory cell array or in the reference bit lines.

In Fig. 6, two matrix bit lines BLⱼ and BL_{z} and two reference bit lines BL_{ref,i} and BL_{ref,h} are shown, representative of all the matrix bit lines and reference bit lines, respectively. The bit lines, shown in dashed lines, are made of metal and run parallely to each other. Also shown in Fig. 6 are portions of five word lines WLₐ to WLₑ, and the reference word line WL_{ref}. The word lines and the reference word line are strips made of an upper polysilicon level, and run substantially parallely to each other in the orthogonal direction compared to that of the bit lines. The word lines form the control gate electrodes of the memory cells. Where the word lines cross the bit lines, under the word lines floating gate electrodes FG made of a lower polysilicon layer are provided.

Between alternate pairs of word lines (e.g., between word lines WLₐ and WL_{b}, WL_{c} and WL_{d}, WLₑ and WL_{ref}) the bit lines contact N+ regions 10 forming a common drain region for the pairs of adjacent cells. Each cell also have an N+ source region 11 which is merged to a respective N+ source line 12 running parallely to the word lines. A plurality of N+ source lines 12 are provided, among alternate pairs of word lines (e.g., word lines WL_{b} and WL_{c}, WL_{d} and WLₑ, etc.). Metal source lines Vs running parallely to the bit lines are interspersed among the bit lines, e.g. one metal source line Vs every *N* bit lines with *N* normally equal to 16 or 32. The metal source lines Vs contact the N+ source lines 12 to bias the latter.

As visible from Fig. 6, in order to implement the sensing arrangement of Fig. 4 all the dummy memory cells M_{dumr} (corresponding to the dummy memory cells M_{dumr,1i}, M_{durmr,2i}...and M_{dumr,1h}, M_{dumr,2h}... of Fig. 4) connected to the reference bit lines BL_{ref,i} and BL_{ref,j} have the source electrodes 11 floating; this is achieved by interrupting the N+ source lines 12, so that the source electrodes 11 of the dummy memory cells M_{dumr} are not electrically connected to the metal source lines Vs. The same is for the dummy memory cells M_{dum,j} and M_{dum,z} provided in the matrix bit lines BLⱼ and BL_{z}. Instead, the reference memory cells M_{ref,i} and M_{ref,h} of the reference bit lines BL_{ref,i} and BL_{ref,h} have the source electrodes 11 connected to an N+ source line 12 that is contacted by the metal source lines Vs.

Even if the layout of Fig. 6 explicitly refers to the sensing arrangement of Fig. 4, it is straightforward for the skilled technician to derive a similar layout for the other sensing arrangements shown in Figs. 3 and 5.

A known technique for the manufacturing of memory cell arrays is that called "Self-Aligned Source" (SAS), described for example in US Patent No. 5,103,274. This technique provides first of all for forming over the semiconductor substrate 100 parallel strips of N+ doped active area, which at the end of the manufacturing process will be located under the metal bit lines. The strips of N+ doped active area are separated by strips of a thick field oxide. After having defined the word lines of the memory cell array, a photolithographic step using a mask called SAS mask is applied to the memory cell array; the SAS mask defines strips (referred to as SAS regions or SAS windows) perpendicular to the strips of field oxide, corresponding to those strips that, at the end of the process, will be the N+ source lines. An etching process is then performed for removing the field oxide along such predefined strips, i.e. the SAS windows. After this photolitographic step, an N type dopant is implanted into these predefined strips to form the N+ source lines of the memory cells.

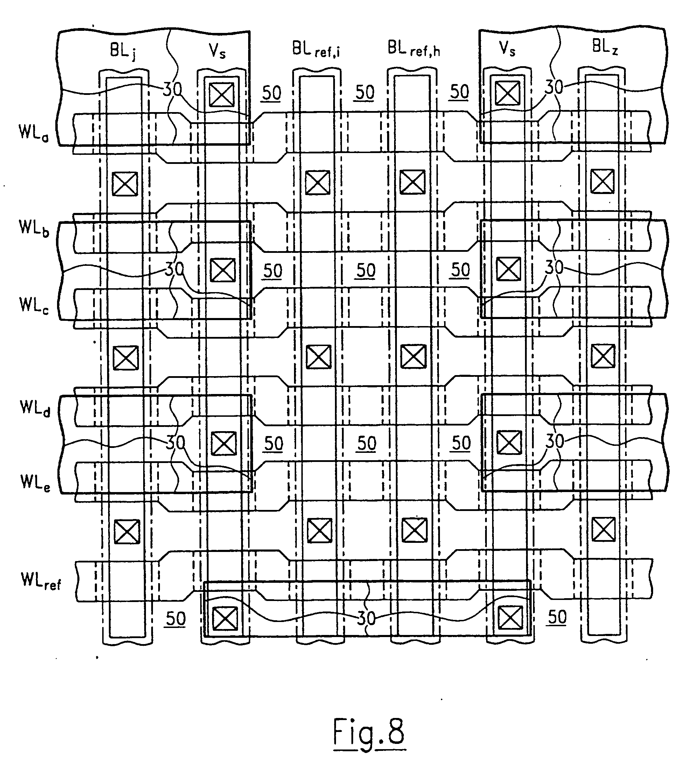

Figure 8 shows how the conventional SAS process can be easily adapted to form a memory cell array conformal to the one shown in Fig. 6.

Fig. 8 shows the same portion of memory cell array shown in Fig. 6, but obtained by a different manufacturing process . For the sake of clarity, in Fig. 8 the SAS windows have been highlighted. The conventional SAS photolithographic mask is modified to provide the results shown in Fig. 8. Instead of having continuous windows in the SAS mask extending substantially along the whole matrix parallely to the word lines, windows 30 in the SAS mask are only provided where it is desired to form the N+ source lines 12 shown in Fig. 6, i.e. for those memory cells that shall have their source electrode 11 connected to the metal source lines Vs. During the following etching step, field oxide regions 50 at both sides of the source region of the dummy memory cells are not removed. Then, an N type dopant is implanted to form the N+ source regions of the memory cells; however, as far as the dummy memory cells are concerned, their source regions will remain isolated due to the presence at both sides thereof of the field oxide regions, masking the underlying semiconductor substrate from the implanted dopant. This occurs for all the dummy cells, i.e., both for the dummy cells belonging to the matrix memory bit lines and for the dummy cells belonging to the reference bit lines.

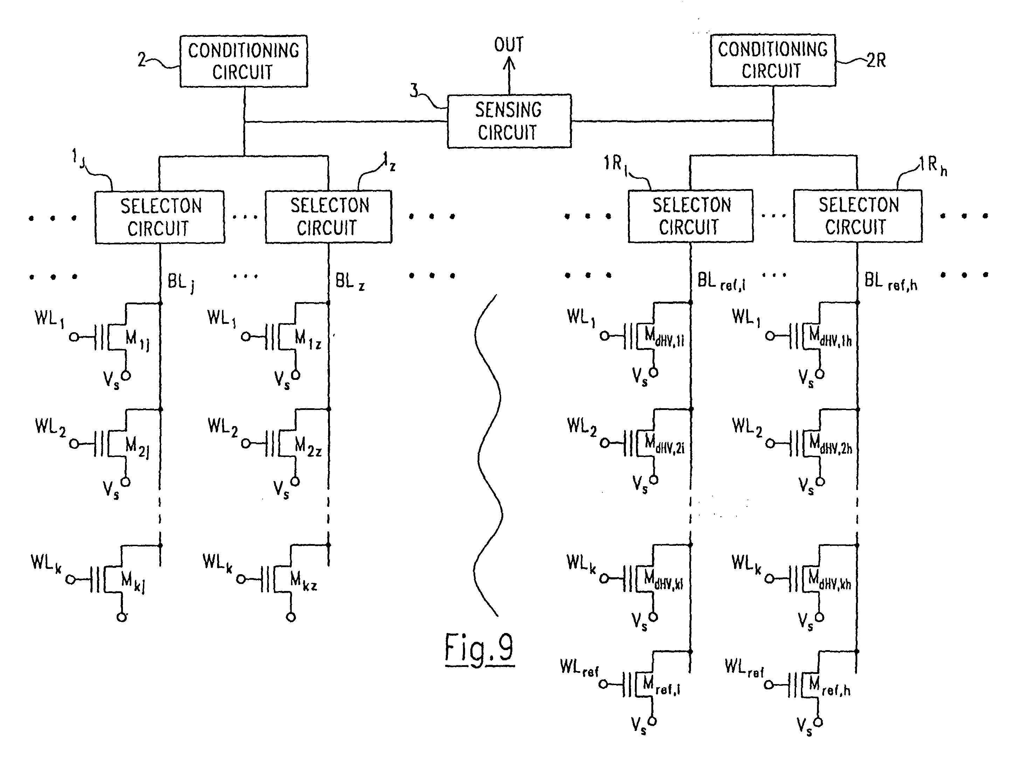

Figs. 9, 10 and 11 shows sensing arrangement for multilevel memory devices corresponding to the embodiments of the present invention the sensing arrangement for multilevel memory devices in Figs. 9, 10 and 11 refer to those which are not part of the claimed invention and which are respectively depicted in Figs. 3, 4 and 5.

Specifically, in Fig. 9, that corresponds to Fig. 3, a sensing arrangement is shown wherein the dummy memory cells of the reference bit lines are replaced by memory cells M_{dHV,li} - M_{dHV,ki} and M_{dHV,lh} - M_{dHV,kh} that instead of having their source electrodes floating, are programmed at a level corresponding to a threshold voltage sufficiently high to make such cells non-conductive at the voltage levels normally applied to the selected word lines WL₁ - WLₖ.

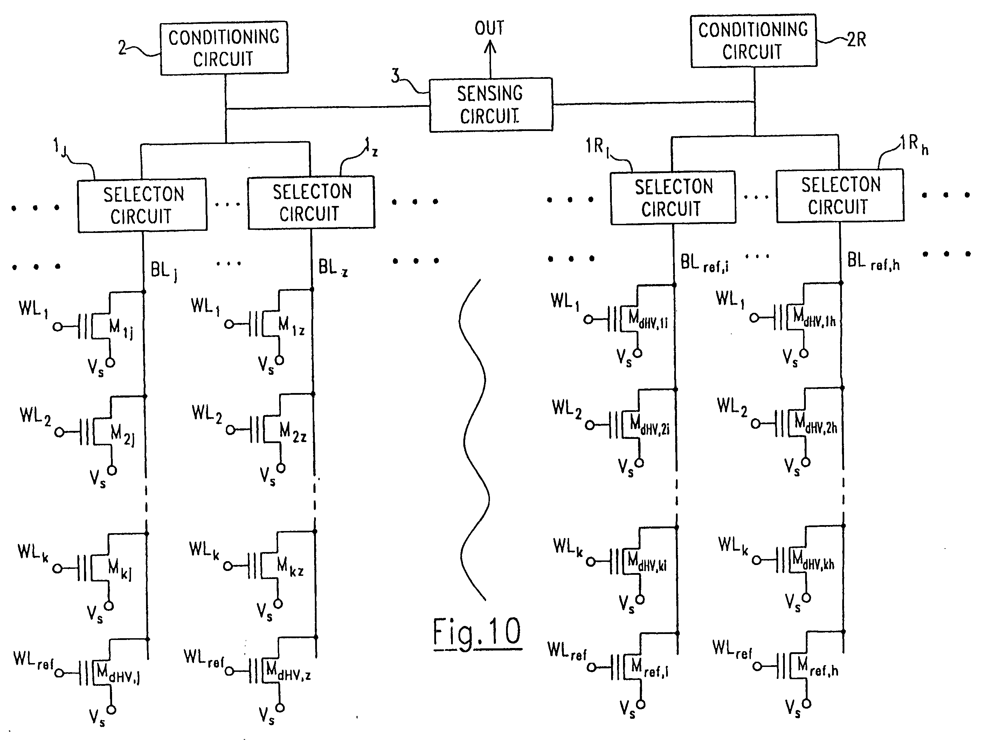

Fig. 10, corresponding to Fig. 4, similarly shows how not only the dummy memory cells of the reference bit lines are memory cells programmed to have a high threshold voltage, as in Fig. 9, but also the dummy cells attached to the matrix bit lines in order to optimize the matching with the reference bit lines are replaced by memory cells M_{dVH,j}, N_{dVH,z} having their source electrodes connected to the source line Vs, but however programmed at a level sufficiently high to make such cells non-conductive at the normal voltage levels applied to the word line WL_{ref} for the selection of the reference memory cells M_{ref,i}, M_{ref,h} of the reference bit lines.

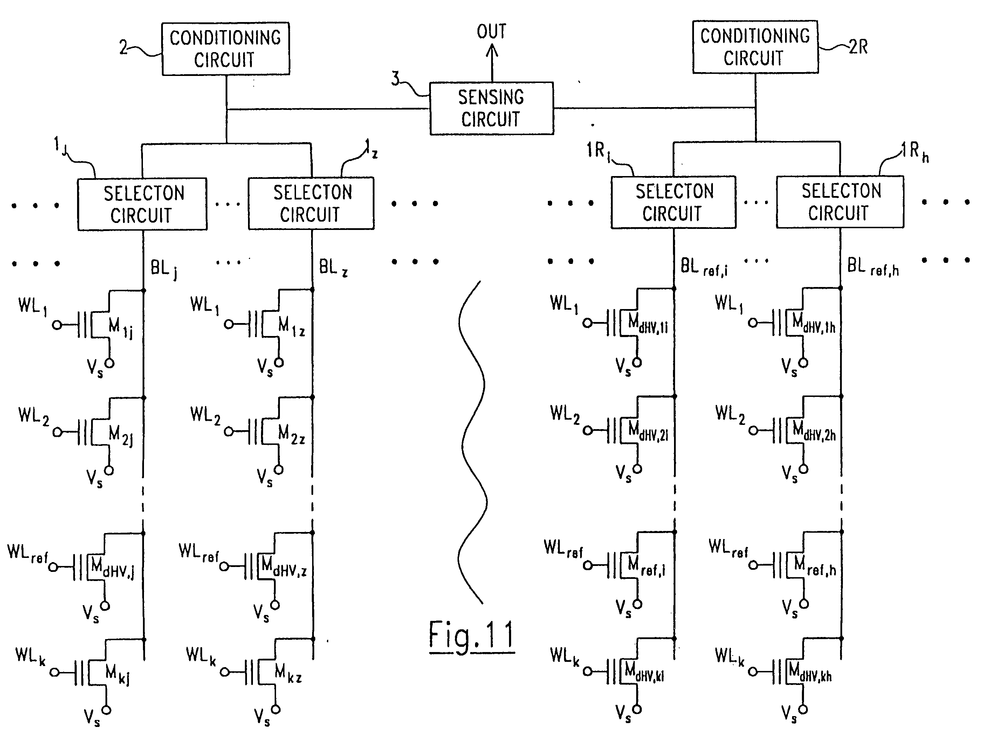

Similarly, Fig. 11 shows the same sensing arrangement of Fig. 10, but with the real reference memory cells M_{ref,i}, M_{ref,h} and the high-threshold voltage cells of the matrix bit lines located at a different position inside the bit lines, e.g. in the middle thereof, instead at one end.

The alternative embodiments shown in Figs. 9, 10 and 11 are simpler, from the layout point of view, than their counterparts of Figs. 3, 4 and 5, respectively. In fact, for the implementation of the sensing arrangements of Figs, 3, 4 and 5 it is necessary, as explained above, to modify the layout of the memory cell array, so as to leave the source electrodes of the dummy memory cells floating. Instead, the embodiments of Figs, 9, 10 and 11 do not require any layout modification, but only a suitable programming of those memory cells that are to be always non-conductive, so as to rise the threshold voltage thereof. This programming step is to be performed before the programming step of the reference memory cells.

All the above-described embodiments allow to simply obtain a good matching between the matrix bit lines and the reference bit lines, but without the need of accurately programming quite a large number of reference memory cells, as instead required by the sensing arrangements according to the prior art.

The area overhead introduced by the sensing arrangements according to the invention is quite small. Let's consider for example the case of a memory device with a memory matrix divided in blocks. Let's also suppose that it is desired to introduce a group of reference bit lines in every block: this situation is the most expensive in terms of device area, but nonetheless it is the one assuring the best matching between the matrix bit lines and the reference bit lines. If the reference bit lines were absent, one source metal line Vs every 16 or 32 matrix bit lines would normally be provided. The layout arrangement would be the following: one source metal line Vs, 16 or 32 matrix bit lines, one source metal line, etc. When the (*m* - 1) reference bit lines are inserted, a good arrangement could be the following: one source metal line Vs, 16 or 32 matrix bit lines, one source metal line Vs, 16 or 32 matrix bit lines....one source metal line Vs, (*m* - 1) reference bit lines, one source metal line Vs, 16 or 32 matrix bit lines, etc. In this way, the memory cell array is substantially not altered from the electrical viewpoint, since the distance between the source electrode of the matrix cells and the source metal line does not change. It appears that the overhead is only given by one additional source metal line Vs and (*m* - 1) reference bit lines for each block of the memory array.

No area overhead at all is instead introduced by using the sensing arrangements of Figures 9, 10 and 11, which only require a proper programming of the dummy cells.

In the previous description, reference has been made for simplicity to a memory cell array with memory cells having source electrodes connected to a common source line Vs, However, it is clear and evident that the present invention applies as well to memory devices having the memory cell array divided in memory sectors, such as sectorized Flash EEPROMs; as known, in this case only the memory cells belonging to a same memory sector have the source electrodes connected to each other, and to a respective memory sector source line distinct from those of the other memory sectors. Thus, all the drawings and the related description can be straightforwardly extended to a sectorized memory device, simply by considering source line Vs as a memory sector source line.

## Claims

1. Multilevel memory device, comprising an array of multilevel memory cells (Mₗⱼ - Mₖⱼ, M_{lz} - M_{kz}) arranged in rows (WL₁ - WLₖ) and columns (BLⱼ, BL_{z}), each memory cell being capable of being programmed in *m* = 2^{*n*} distinct programming states, wherein n > 1, and a sensing arrangement for sensing the memory cells, the sensing arrangement comprising at least *m* - 1 reference columns (BL_{ref,i}, BL_{ref,h}) of memory cells, each one of said reference columns comprises a number of memory cells substantially identical to the number of memory cells of each column of the array, a smaller number of memory cells (M_{ref,l}, M_{ref,h}) of each reference column being multilevel reference memory cells programmed in a respective reference programming state and activatable for sinking a respective reference current (I_{R,0},I_{R,1},I_{R,2}), the remaining larger number of memory cells of each reference column being dummy non-conductive memory cells (M_{dumr,li} - M_{dumr,ki}, M_{dumr,lh} - M_{dumr,kh}) structurally identical to the reference memory cells and to the memory cells of the array;
**characterized in that** the multilevel memory cells (Mₗⱼ - Mₖⱼ, M_{lz} - M_{kz}), the dummy memory cells (M_{dumr,li} - M_{dumr,ki}, M_{dumr,lh} - M_{dumr,kh}; M_{dum,l},M_{dum,h}) and the reference memory cells (M_{ref,l,}M_{ref,h}) comprise MOS transistors having a drain electrode connected to the respective column or reference column, a control electrode connected to a respective row or reference row line, and a source electrode connected to a source line (Vs), and the dummy memory cells are programmed at a programming state suitable for making the dummy cells non-conductive when their control electrode and drain electrode are biased with voltages normally used in sensing operations.

2. Multilevel memory device according to claim 1, **characterized in that** said smaller number of memory cells of each reference column comprises one reference memory cell (M_{ref,l}, M_{ref,h}).

3. Multilevel memory device according to claim 2, **characterized in that** the dummy non-conductive memory cells (M_{dumr,li} - M_{dumr,ki}, M_{dumr,lh} - M_{dumr,kh}) of the reference columns are each one connected to a respective one of the rows (WL₁ - WLₖ) of the array, while the reference memory cells (M_{ref,i}, M_{ref,h}) are connected to a reference row line (WL_{ref}) activatable for activating the reference memory cells.

4. Multilevel memory device according to claim 3, **characterized in that** the reference memory cells (M_{ref,i},M_{ref,h}) are located at one end of the respective reference column (BL_{ref,i},BL_{ref,h}).

5. Multilevel memory device according to claim 3, **characterized in that** the reference memory cells (M_{ref,i},M_{ref,h}) are located among the dummy memory cells (M_{dumr,li} - M_{dumr,ki}, M_{dumr,lh} - M_{dumr,kh}) of the respective reference column (BL_{ref,i},BL_{ref,h}), particularly in the middle of the respective reference column.

6. Multilevel memory device according to any one of claims 3 to 5, **characterized in that** each one of said columns (BLⱼ,BL_{z}) of the array comprises, in addition to the respective multilevel memory cells (Mₗⱼ - Mₖⱼ,M_{lz} - M_{kz}), an additional dummy non-conductive memory cell (M_{dum,j},M_{dum,z}), so that the columns of the array comprise a number of memory cells exactly equal to the number of memory cells of the reference columns (BL_{ref,i},BL_{ref,h}).

7. Multilevel memory device according to claim 6, **characterized in that** the dummy memory cells (M_{dum,j},M_{dum,h}) of the columns (BLⱼ,BL_{z}) of the array are connected to said reference row line (WL_{ref}).

8. Multilevel memory device according to any one of the preceding claims, **characterized in that** said reference columns (BL_{ref,i},BL_{ref,h}) are located inside the array of multilevel memory cells.

9. Multilevel memory device according to claim 1, **characterized in that** the source electrodes of the memory cells (Mₗⱼ - Mₖⱼ, M_{lz} - M_{kz}) and of the reference memory cells (M_{ref,i},M_{ref,h}) are connected to a common source line (Vs).

10. Multilevel memory device according to claim 1, **characterized in that** said array of multilevel memory cells comprises at least two memory sectors, the source electrodes of the memory cells and of the reference memory cells of one memory sector being connected to a common sector source line distinct from a sector source line of the other memory sectors.

## Patentansprüche

1. Mehrfachpegelspeichervorrichtung mit
einem Feld von Mehrfachpegelspeicherzellen (Mₗⱼ,-Mₖⱼ, M_{lz}-M_{kz}), die in Zeilen (WL₁-WLₖ) und Spalten (BLⱼ, BL_{z}) angeordnet sind, wobei jede Speicherzelle in m=2ⁿ verschiedenen Programmierzuständen programmiert werden kann mit n>1, und
einer Leseanordnung zum Auslesen der Speicherzellen, wobei die Leseanordnung zumindest m-1 Referenzspalten (BL_{ref,i}, BL_{ref,h}) mit Speicherzellen enthält,
wobei jede dieser Referenzspalten eine Anzahl von Speicherzellen enthält, die im Wesentlichen gleich der Anzahl von Speicherzellen jeder Spalte des Feldes ist,
eine kleinere Anzahl von Speicherzellen (M_{ref,i}, M_{ref,h}) jeder Referenzspalte Mehrfachpegelreferenzspeicherzellen sind, die in einem jeweiligen Referenzprogrammierzustand programmiert sind und zum Ziehen eines jeweiligen Referenzstroms (I_{R,0}, I_{R,1}, I_{R,2}) aktiviert werden können,
die verbleibende größere Anzahl von Speicherzellen jeder Referenzspalte nichtleitende Dummyspeicherzellen (M_{dumr,li}, -M_{dumr,ki}, M_{dumr,lh}-M_{dumr,kh}) sind, deren Aufbau identisch zu dem der Referenzspeicherzellen und der Speicherzellen des Feldes sind,
**dadurch gekennzeichnet, dass**
die Mehrfachpegelspeicherzellen (Mₗⱼ,-Mₖⱼ, M_{lz}-M_{kz}), die Dummyspeicherzellen (M_{dumr,li},-M_{dumr,ki}, M_{dumr,lh}-M_{dumr,kh}; M_{dum,j}, M_{dum,h}) und die Referenzspeicherzellen (M_{ref,i}, M_{ref,h}) MOS-Transistoren enthalten, bei denen eine Drainelektrode mit der jeweiligen Spalte oder Referenzspalte verbunden ist, eine Steuerelektrode mit einer entsprechenden Zeilen- oder Referenzzeilenleitung verbunden ist und eine Sourceelektrode mit einer Sourceleitung (V_{S}) verbunden ist, und
die Dummyspeicherzellen in einem Programmierzustand programmiert sind, der geeignet ist, die Dummyzellen nichtleitend zu machen, wenn ihre Steuerelektrode und Drainelektrode mit Spannungen vorgespannt werden, die normalerweise bei Lesevorgängen verwendet werden.

2. Mehrfachpegelspeichervorrichtung nach Anspruch 1, **dadurch gekennzeichnet, dass**
die kleinere Anzahl von Speicherzellen jeder Referenzspalte eine Referenzspeicherzelle (M_{ref,i}, M_{ref,h}) enthält

3. Mehrfachpegelspeichervorrichtung nach Anspruch 2, **dadurch gekennzeichnet, dass**
von den nichtleitenden Dummyspeicherzellen (M_{dumr,li}, -M_{dumr,ki}, M_{dumr,lh}-M_{dumr,kh}) der Referenzspalten jede mit einer jeweiligen Zeile (WL₁-WLₖ) verbunden ist, während
die Referenzspeicherzellen (M_{ref,i}, M_{ref,h}) mit einer Referenzzeilenleitung (WL_{ref}) sind, die zum Aktivieren der Referenzspeicherzellen aktiviert werden kann.

4. Mehrfachpegelspeichervorrichtung nach Anspruch 3, **dadurch gekennzeichnet, dass**
die Referenzspeicherzellen (M_{ref,i}, M_{ref,h}) an einem Ende der jeweiligen Referenzspalte (BL_{ref,i}, BL_{ref,h}) angeordnet sind.

5. Mehrfachpegelspeichervorrichtung nach Anspruch 3, **dadurch gekennzeichnet, dass**
die Referenzspeicherzellen (M_{ref,i}, M_{ref,h}) zwischen den Dummyspeicherzellen (M_{dumr,li},-M_{dumr,ki}, M_{dumr,lh}-M_{dumr,kh}) der jeweiligen Referenzspalte (BL_{ref,i}, BL_{ref,h}) angeordnet sind, insbesondere in der Mitte der jeweiligen Referenzspalte.

6. Mehrfachpegelspeichervorrichtung nach einem der Ansprüche 3 bis 5, **dadurch gekennzeichnet, dass**
jede der Spalten (BLⱼ, BL_{z}) des Feldes zusätzlich zu den jeweiligen Mehrfachpegelspeicherzellen (Mₗⱼ,-Mₖⱼ, M_{lz}-M_{kz}), eine zusätzliche nichtleitende Dummyspeicherzelle (M_{dum,j}, M_{dum,h}) enthält, so dass die Spalten des Feldes eine Anzahl von Speicherzellen enthalten, die exakt gleich groß ist wie die Anzahl der Speicherzellen der Referenzspalten (BL_{ref,i}, BL_{ref,h}).

7. Mehrfachpegelspeichervorrichtung nach Anspruch 6, **dadurch gekennzeichnet, dass**
die Dummyspeicherzellen (M_{dum,j}, M_{dum,h}) der Spalten (BLⱼ, BL_{z}) des Feldes mit der Referenzzeilenleitung (WL_{ref}) verbunden sind.

8. Mehrfachpegelspeichervorrichtung nach einem der vorigen Ansprüche, **dadurch gekennzeichnet, dass**
die Referenzspalten (BL_{ref,i}, BL_{ref,h}) innerhalb des Feldes von Mehrfachpegelspeicherzellen angeordnet sind.

9. Mehrfachpegelspeichervorrichtung nach Anspruch 1, **dadurch gekennzeichnet, dass**
die Sourceelektroden der Speicherzellen (Mₗⱼ,-Mₖⱼ, M_{lz}-M_{kz}) und der Referenzspeicherzellen (M_{ref,i}, M_{ref,h}) mit einer gemeinsamen Sourceleitung (V_{S}) verbunden sind.

10. Mehrfachpegelspeichervorrichtung nach Anspruch 1, **dadurch gekennzeichnet, dass**
das Feld von Mehrfachpegelspeicherzellen zumindest zwei Speicherbereiche enthält, wobei die Sourceelektroden der Speicherzellen und der Referenzspeicherzellen eines Speicherbereichs mit einer gemeinsamen Bereichssourceleitung verbunden sind, die von einer Bereichssourceleitung des anderen Speicherbereichs verschieden ist.

## Revendications

1. Dispositif de mémoire à plusieurs niveaux, comprenant un réseau de cellules de mémoire à plusieurs niveaux (Mₗⱼ-Mₖⱼ, M_{lz}, M_{kz}) agencées en rangées (WL₁-WLₖ) et en colonnes (BLⱼ-BL_{z}), chaque cellule de mémoire étant capable d'être programmée dans m = 2ⁿ états de programmation distincts, où n > 1, et un ensemble de détection destiné à détecter les cellules de mémoire, l'ensemble de détection comprenant au moins m - 1 colonnes de référence (BL_{ref,i}, BL_{ref,h}) de cellules de mémoire, chacune desdites colonnes de référence comprenant un certain nombre de cellules de mémoire sensiblement identique au nombre de cellules de mémoire de chaque colonne du réseau, un nombre moins élevé de cellules de mémoire (M_{ref,i}, M_{ref,h}) de chaque colonne de référence étant des cellules de mémoire de référence à plusieurs niveaux programmées dans un état de programmation de référence respectif et activables afin de réduire un courant de référence respectif (I_{R,0}, I_{R,1}, I_{R,2}), le nombre plus élevé restant de cellules de mémoire de chaque colonne de référence étant des cellules de mémoire non conductrices factices (M_{dumr,li} - M_{dumr,ki}, M_{dumr,lh} - M_{dumr,kh}) structurellement identiques aux cellules de mémoire de référence et aux cellules de mémoire du réseau ;
**caractérisé en ce que** les cellules de mémoire à plusieurs niveaux (Mₗⱼ-Mₖⱼ, M_{lz}, M_{kz}), les cellules de mémoire factices (M_{dumr,li} - M_{dumr,ki}, M_{dumr,lh}, M_{dumr,kh}, M_{dum,j} - M_{dum,h}) et les cellules de mémoire de référence (M_{ref,i}, M_{ref,h}) comprennent des transistors à semi-conducteurs en oxyde métallique possédant une électrode déversoir reliée à la colonne respective ou à la colonne de référence, une électrode de commande reliée à une rangée respective ou à une ligne de rangée de référence, et une électrode source reliée à une ligne de source (V_{S}), et les cellules de mémoire factices sont programmées dans un état de programmation convenant pour rendre les cellules factices non conductrices lorsque leur électrode de commande et leur électrode déversoir sont polarisées avec des tensions normalement utilisées lors d'opérations de détection.

2. Dispositif de mémoire à plusieurs niveaux selon la revendication 1, **caractérisé en ce que** ledit nombre moins élevé de cellules de mémoire de chaque colonne de référence comprend une cellule de mémoire de référence (M_{ref,i}, M_{ref,h}).

3. Dispositif de mémoire à plusieurs niveaux selon la revendication 2, **caractérisé en ce que** les cellules de mémoire non conductrices factices (M_{dumr,li} - M_{dumr,ki}, M_{dumr,lh} - M_{dumr,kh}) des colonnes de référence sont chacune reliées à l'une des rangées respectives (WL₁ - WLₖ) du réseau, tandis que les cellules de mémoire de référence (M_{ref,i}, M_{ref,h}) sont reliées à une ligne de rangée de référence (WL_{ref}) activable afin d'activer les cellules de mémoire de référence.

4. Dispositif de mémoire à plusieurs niveaux selon la revendication 3, **caractérisé en ce que** les cellules de mémoire de référence (M_{ref,i}, M_{ref,h}) sont situées à une extrémité de la colonne de référence respective (BL_{ref,i}, BL_{ref,h}).

5. Dispositif de mémoire à plusieurs niveaux selon la revendication 3, **caractérisé en ce que** les cellules de mémoire de référence (M_{ref,i}, M_{ref,h}) sont situées parmi les cellules de mémoire factices (M_{dumr,li} - M_{dumr,ki}, M_{dumr,lh} - M_{dumr,kh}) de la colonne de référence respective (BL_{ref,i}, BL_{ref,h}), particulièrement au milieu de la colonne de référence respective.

6. Dispositif de mémoire à plusieurs niveaux selon l'une quelconque des revendications 3 à 5, **caractérisé en ce que** chacune desdites colonnes (BLⱼ, BL_{z}) du réseau comprend, en plus des cellules de mémoire à plusieurs niveaux respectives (Mₗⱼ-Mₖⱼ, M_{lz}, M_{kz}), une cellule de mémoire non conductrice factice supplémentaire (M_{dum,j}, M_{dum,z}), de telle sorte que les colonnes du réseau comprennent un certain nombre de cellules de mémoire exactement égal au nombre de cellules de mémoire des colonnes de référence (BL_{ref,i}, BL_{ref,h}).

7. Dispositif de mémoire à plusieurs niveaux selon la revendication 6, **caractérisé en ce que** les cellules de mémoire factices (M_{dum,j}, M_{dum,h}) des colonnes (BLⱼ, BL_{z}) du réseau sont reliées à ladite ligne de rangée de référence (WL_{ref}).

8. Dispositif de mémoire à plusieurs niveaux selon l'une quelconque des revendications précédentes, **caractérisé en ce que** lesdites colonnes de référence (BL_{ref,i}, BL_{ref,h}) sont situées à l'intérieur du réseau de cellules de mémoire à plusieurs niveaux.

9. Dispositif de mémoire à plusieurs niveaux selon la revendication 1, **caractérisé en ce que** les électrodes source des cellules de mémoire (Mₗⱼ-Mₖⱼ, M_{lz}, M_{kz}) et des cellules de mémoire de référence (M_{ref,i}, M_{ref,h}) sont reliées à une ligne de source commune (V_{S}).

10. Dispositif de mémoire à plusieurs niveaux selon la revendication 1, **caractérisé en ce que** ledit réseau de cellules de mémoire à plusieurs niveaux comprend au moins deux secteurs de mémoire, les électrodes source des cellules de mémoire et des cellules de mémoire de référence d'un secteur de mémoire étant reliées à une ligne de source de secteur commune distincte d'une ligne de source de secteur des autres secteurs de mémoire.
